(19) Europäisches Patentamt
European Patent Office
Office européen des brevets

(11) EP 0 447 868 B1

(12) **EUROPÄISCHE PATENTSCHRIFT**

(45) Veröffentlichungstag und Bekanntmachung des Hinweises auf die Patenterteilung:
**05.06.1996 Patentblatt 1996/23**

(51) Int Cl.[6]: **G03F 7/039**

(21) Anmeldenummer: **91103276.1**

(22) Anmeldetag: **05.03.1991**

# (54) Strahlungsempfindliches Gemisch

Radiation sensitive mixture

Mélange sensible aux radiations

(84) Benannte Vertragsstaaten:
**AT CH DE FR GB IT LI NL SE**

(30) Priorität: **13.03.1990 DE 4007924**

(43) Veröffentlichungstag der Anmeldung:
**25.09.1991 Patentblatt 1991/39**

(73) Patentinhaber: **BASF Aktiengesellschaft**
**D-67063 Ludwigshafen (DE)**

(72) Erfinder: **Nguyen, Kim, Son, Dr.**
**W-6944 Hemsbach (DE)**

(56) Entgegenhaltungen:
**EP-A- 0 297 443** **EP-A- 0 342 498**

- **PATENT ABSTRACTS OF JAPAN vol. 12, no. 339 (P-757)(3186) 12 September 1988, & JP-A-63 097947**

Bemerkungen:
Die Akte enthält technische Angaben, die nach dem Eingang der Anmeldung eingereicht wurden und die nicht in dieser Patentschrift enthalten sind.

EP 0 447 868 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft positiv arbeitende strahlungsempfindliche Gemische, die ein in Wasser unlösliches, in wäßrig-alkalischen Lösungen lösliches Bindemittel und eine unter Einwirkung von Strahlung eine Säure bildende Verbindung, enthalten, wobei das Bindemittel bestimmte Gruppierungen enthält, die durch säurekatalytische Einwirkung verseift werden, wodurch die Alkalilöslichkeit des Gemisches erhöht wird. Diese Gemische sind sensitiv gegenüber UV-, Elektronen- und Röntgenstrahlen und eignen sich besonders als Resistmaterial.

Positiv arbeitende strahlungsempfindliche Gemische sind bekannt und besonders positiv arbeitende Resistmaterialien, die o-Chinondiazide in wäßrig-alkalisch löslichen Bindemitteln, z.B. Novolaken oder Poly(p-vinylphenol)en, enthalten, werden kommerziell eingesetzt. Die Empfindlichkeit dieser Systeme gegenüber Strahlung, insbesondere kurzwelliger Strahlung, ist jedoch teilweise unbefriedigend.

Empfindlichkeitserhöhungen in strahlungsempfindlichen Systemen, die in der Primärphotoreaktion eine Spezies erzeugen, die dann unabhängig von der Strahlung eine katalytische Sekundärreaktion auslöst, sind beschrieben. So sind in der US-A 3,915,706 beispielsweise Photoinitiatoren beschrieben, die eine starke Säure erzeugen, die dann in einer Sekundärreaktion säurelabile Gruppen, wie Polyaldehydgruppierungen spalten.

Weiterhin sind strahlungsempfindliche Gemische auf Basis von säurespaltbaren Verbindungen bekannt, die als Bindemittel ein wäßrig-alkalisch lösliches Polymer sowie eine Verbindung, die photochemisch eine starke Säure bildet, und eine weitere Verbindung mit durch Säure spaltbaren Bindungen, die durch die Einwirkung der Säure ihre Löslichkeit in einem alkalischen Entwickler erhöhen, enthalten (vgl. DE-A 3 406 927). Als photochemisch eine starke Säure bildende Verbindungen werden Diazonium-, Phosphonium-, Sulfonium- und Iodonium-, sowie Halogenverbindungen genannt. Die Verwendung dieser Oniumsalze als photochemische Säurespender in Resistmaterialien ist z.B. auch aus US-A 4,491,628 bekannt. Einen Überblick über die Anwendung von Oniumsalzen in Resistmaterialien gibt Crivello in Org. Coatings and Appl. Polym. Sci., 48, p. 65-69 (1985).

Strahlungsempfindliche Gemische von Polymeren mit säurelabilen Seitengruppen und photochemischen Säurespendern sind z.B. aus US-A 4,491,628 und FR-A 2,570,844 bekannt. Diese polymeren Bindemittel sind jedoch hydrophob und werden erst nach der Belichtung alkalilöslich.

Copolymere mit phenolischen und säurelabilen Gruppen, wie beispielsweise Poly-(p-hydroxistyrol-co-t-butoxicarbonyloxistyrol), sind aus J. Polym. Sci., Part A, Polym. Chem. Ed., Vol. 24, 2971-2980 (1986) bekannt. Verwendet man jedoch diejenigen Copolymeren dieser Gruppe, die noch alkalilöslich sind, in Verbindung mit den kommerziellen Sulfoniumsalzen, wie Triphenylsulfoniumhexafluoroarsenat, wie auch in US-A 4,491,628 beschrieben, so haben diese Gemische den Nachteil, daß ein sehr hoher Abtrag der unbelichteten Bereiche stattfindet, da die genannten Sulfoniumsalze nicht genügend zur Löslichkeitsinhibierung beitragen.

In der DE-A 37 21 741 werden strahlungsempfindliche Gemische beschrieben, die ein in wäßrig-alkalischen Lösungen lösliches polymeres Bindemittel enthalten sowie eine organische Verbindung, deren Löslichkeit in einem wäßrig-alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt.

Aus der DE-C 23 06 248 ist ein durch Belichten löslich werdendes Stoffgemisch und ein lichtempfindliches Aufzeichnungsmaterial bekannt, das ein phenolisches Bindemittel, einen photoaktiven Säurespender (halogenhaltiges s-Triazinderivat oder Diazoniumsalz) und ein Reaktionsprodukt einer mindestens eine Alkylvinylethergruppe enthaltenden organischen Verbindung mit einem ein- oder mehrwertigen Phenol, d.h. ein Dreikomponentensystem enthält. Diese Systeme weisen jedoch zu geringe thermische Stabilität auf und ergeben Struktureigenschaften, die sie für den Submikronbereich ungeeignet machen.

Aus CA Selects: Photoresist, Issue 1, 1990, 244016m ist Polyhydroxistyrol, dessen Hydroxylgruppen durch Tetrahydropyranyl- und Tetrahydrofuranylgruppen geschützt sind, und das mit bis(tert.-butylphenyl)jodoniumtriflat kombiniert wird, bekannt. Ebenso ist aus PME 1989 (= Polymers for Microelectronics-Science and Technology), Seiten 66-67 Polyhydroxistyrol, dessen OH-Gruppen teilweise durch Tetrahydropyranylgruppen ersetzt sind, in Kombination mit Triphenylsulfoniumtriflat bekannt. Nachteilig bei den beiden zuletzt genannten Systemen ist, daß sie bei Überbelichtung nicht mehr positiv, sondern negativ arbeitend sind, was ihre Anwendbarkeit stark einschränkt.

In der US-A 4 101 323 sind strahlungsempfindliche Kopiermassen beschrieben, die Bindemittel, die in der Hauptkette säurespaltbare -C-O-C-Gruppierungen enthalten, sowie eine Polychlorverbindung als Säurespender enthalten. In EP-A 302 359 sind strahlungsempfindliche Kopiermassen beschrieben, die ein Dreikomponentensystem aus alkalilöslichem phenolischem Bindemittel, einer Polychlorverbindung als Säurespender und einer Verbindung mit zwei Acetalgruppen als Inhibitor enthalten. Während die in oben genannter US-Patentschrift beschriebenen Kopiermassen ungenügende Reproduzierbarkeit bei ihrer Herstellung aufweisen, ergeben sich bei den in der EP-A beschriebenen Kopiermassen die bereits oben genannten Nachteile der Dreikomponentensysteme.

Aufgabe der vorliegenden Erfindung ist es, neue positiv arbeitende hochaktive strahlungsempfindliche Systeme für die Herstellung von Reliefstrukturen aufzuzeigen, die sich mit wäßrig-alkalischen Lösungen entwickeln lassen und die Herstellung von im kurzwelligen UV lichtempfindlichen Schichten ermöglichen.

Dazu soll ein strahlungsempfindliches Gemisch, das ein in Wasser unlösliches, in wäßrig-alkalischer Lösung lösliches Bindemittel mit einer säurelabilen Gruppierung, die durch Einwirkung von Säure verseift wird, und eine bei Bestrahlung eine starke Säure bildende Verbindung enthält, bildmäßig bestrahlt, erwärmt und die bildmäßig bestrahlten Schichtbereiche mit Entwicklerlösung ausgewaschen werden.

In der EP-A-0 342 498 werden positiv und negativ arbeitende strahlungsempfindliche Gemische sowie Verfahren zur Herstellung von Reliefmustern beschrieben, wobei ein Umsetzungsprodukt aus einem phenolische Hydroxylgruppen enthaltenden Polymeren mit Dihydropyran oder einem Alkylvinylether oder ein durch Polymerisation oder Polykondensation von Umsetzungsprodukten phenolische Hydroxylgruppen enthaltender monomerer Verbindungen mit Dihydropyran oder einem Alkylvinylether erhaltenes Polymerisat oder Polykondensat mit einer organischen Verbindung, deren Löslichkeit in einem wäßrig-alkalischen Entwickler durch Einwirkung von Säure erhöht wird und die mindestens eine durch Säure spaltbare Gruppierung sowie eine zusätzliche Gruppierung, die unter Einwirkung von Strahlung eine starke Säure bildet, enthält, kombiniert wird.

Überraschenderweise wurde gefunden, daß durch den Ersatz von 20 bis 70 % der phenolischen Hydroxylgruppen des Bindemittels durch bestimmte Acetalgruppierungen hochaktive strahlungsempfindliche Systeme für die Herstellung von Reliefstrukturen im kurzwelligen UV erhalten werden, die sich besonders durch sehr gute Reproduzierbarkeit und hohe Auflösung auszeichnen.

Gegenstand der vorliegenden Erfindung ist ein strahlungsempfindliches Gemisch, im wesentlichen bestehend aus

(a) einem in Wasser unlöslichen, in wäßrig-alkalischen Lösungen löslichen Bindemittel oder Bindemittelgemisch und

(b) einer bei Bestrahlung eine starke Säure bildenden Verbindung,

das dadurch gekennzeichnet ist, daß Komponente (a) ein phenolisches Harz ist, dessen phenolische Hydroxylgruppen zu 20 bis 70 % durch Gruppierungen (I)

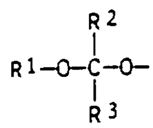

(I),

worin

$R^1$ für Alkyl steht,
$R^2$ für Alkyl steht und
$R^3$ für Wasserstoff oder Alkyl steht,

oder $R^1$ zusammen mit $R^2$ über $-(CH_2)_m-$ mit m = 3 bis 6 einen Ring bildet,
ersetzt sind, und als Komponente (b) ein Sulfonium- oder Jodoniumsalz der allgemeinen Formeln (V) oder (VI)

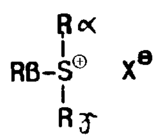

bzw.

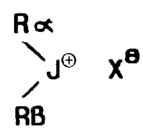

(V) (VI)

eingesetzt wird, worin Rα, Rβ und Rγ untereinander gleich oder verschieden sind und für Alkyl mit 1 bis 3 Kohlenstoffatomen, Aryl
oder Aralkyl stehen und $X^{\ominus} = ClO_4^{\ominus}$, $AsF_6^{\ominus}$, $SbF_6^{\ominus}$, $PF_6^{\ominus}$, $BF_4^{\ominus}$, $CH_3SO_3^{\ominus}$ und/oder $CF_3SO_3^{\ominus}$ ist, wobei mindestens einer der Reste Rα, Rβ und Rγ für einen Rest der allgemeinen Formel (VII)

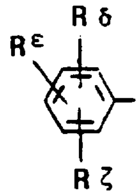

(VII)

steht, worin Rδ, Rε und Rζ untereinander gleich oder verschieden sind und für H, OH, Halogen oder Alkyl mit 1 bis 4 Kohlenstoffatomen stehen.

Als Komponente (a) können Poly-(-p-hydroxistyrol) oder Poly-(p-hydroxi-α-methylstyrol) mit mittleren Molekulargewichten $\overline{M}_w$ zwischen 200 und 200 000 eingesetzt werden, wobei 20 bis 70 %, vorzugsweise 25 bis 60 % der phenolischen Hydroxylgruppen durch die Gruppierung (I) ersetzt sind.

Bevorzugt als Bindemittel-Komponente (a) sind solche, die Gruppierungen (II) und (III) oder (II) und (IV)

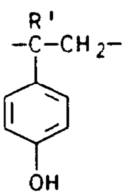

(II)

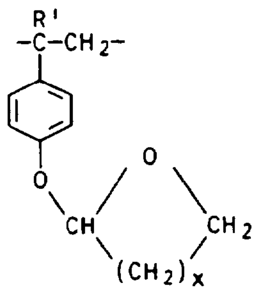

(III)

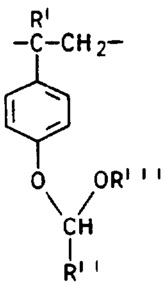

(IV)

enthalten, wobei x = 2 oder 3 ist, R' für H oder $CH_3$ steht, R'' und R''' untereinander gleich oder verschieden sind und für Alkyl mit 1 bis 4 Kohlenstoffatomen stehen, wie die Copolymerisate aus p-Hydroxystyrol und 2-Tetrahydropyranyloxistyrol oder 2-Tetrahydrofuranyloxistyrol - wobei diese Copolymerisate auch durch polymeranaloge Umsetzung hergestellt sein können - .

Als Komponente (b) enthalten die erfindungsgemäßen strahlungsempfindlichen Gemische Sulfonium- oder Jodoniumsalze der allgemeinen Formeln (V) oder (VI),

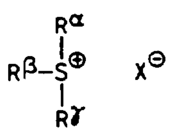

oder

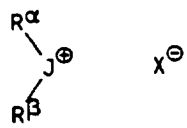

(V) (VI)

worin Rα, Rβ und Rγ untereinander gleich oder verschieden sind und für Alkyl mit 1 bis 3 Kohlenstoffatomen, Aryl, oder Aralkyl stehen und $X^{\ominus}$= $ClO_4^{\ominus}$, $AsF_6^{\ominus}$ , $SbF_6^{\ominus}$, $PF_6^{\ominus}$, $BF_4^{\ominus}$, $CH_3SO_3^{\ominus}$ und/oder $CF_3SO_3^{\ominus}$ ist, wobei mindestens einer der Reste Rα, Rβ und Rγ für einen Rest der allgemeinen Formel (VII)

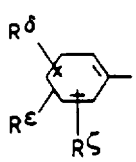

(VII)

steht, worin Rδ, Rε und Rζ untereinander gleich oder verschieden sind und für H, OH, Halogen oder Alkyl mit 1 bis 4 Kohlenstoffatomen stehen.

Die erfindungsgemäßen strahlungsempfindlichen Gemische enthalten Komponente (a) im allgemeinen in einer Menge von 80 bis 99 Gew.-% und Komponente (b) in einer Menge von 1 bis 20 Gew.-%.

Die erfindungsgemäßen Gemische können zusätzlich Sensibilisatoren enthalten, die Strahlung absorbieren und auf Komponente (b) übertragen, bzw. zusätzlich bis zu 1 Gew.-% eines Haftvermittlers, Tensids oder Farbstoffs.

Gegenstand der vorliegenden Erfindung ist auch ein Verfahren zur Herstellung lichtempfindlicher Beschichtungs-

materialien, wobei erfindungsgemäße strahlungsempfindliche Gemische eingesetzt werden, sowie ein Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 130°C, bildmäßiges Belichten, gegebenenfalls Erhitzen auf Temperaturen von 70 bis 160°C, und Entwickeln mit einer wäßrig-alkalischen Lösung, wobei erfindungsgemäße strahlungsempfindliche Gemische eingesetzt werden.

Das erfindungsgemäße System ist besonders vorteilhaft, da es sich in Kombination mit den besonders preisgünstigen Bindemitteln auf Novolak-Basis einsetzen läßt. Die damit erhaltenen Reliefstrukturen zeichnen sich durch sehr gute Reproduzierbarkeit und hohe Auflösung aus.

Zu den Aufbaukomponenten des erfindungsgemäßen strahlungsempfindlichen Gemisches ist im einzelnen folgendes auszuführen.

a) Als in Wasser unlösliche, in wäßrig-alkalischen Lösungen lösliche Bindemittel oder Bindemittelgemische kommen wegen der meist erforderlichen Plasmaätzstabilität phenolische Harze in Betracht, deren phenolische Hydroxylgruppen zu 20 bis 70, insbesondere 25 bis 60 % durch die Gruppierung (I) ersetzt sind, wie z.B. entsprechende Novolake mit Molekulargewichten $\overline{M}_w$ zwischen 300 und 20.000, vorzugsweise zwischen 300 und 2000 g/mol, für Belichtung im kurzwelligen UV-Bereich (≤ 300 nm) insbesondere Novolake auf Basis p-Kresol/Formaldehyd, Poly (p-hydroxistyrole) und Poly(p-hydroxi-α-methylstyrole), wobei diese Poly(p-hydroxistyrole) im allgemeinen Molekulargewichte $\overline{M}_w$ zwischen 200 und 200.000, vorzugsweise zwischen 1000 und 40.000 g/mol aufweisen. Diese Poly(p-hydroxistyrole) können auch in bekannter Weise durch Umsetzung (polymeranaloge Umsetzung) ihrer Hydroxylgruppen mit z.B. 3,4-Dihydropyran, Dihydrofuran, erfindungsgemäß modifiziert sein. Die so erhältlichen und im vorliegenden Falle auch als Copolymerisate verstandenen modifizierten polymeren Bindemittel (a) sind vorzugsweise solche, die im wesentlichen aus Gruppierungen (II) und (III) oder (II) und (IV) bestehen,

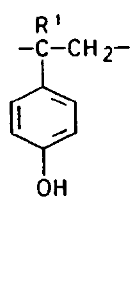
(II)

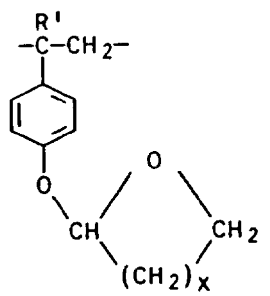
(III)

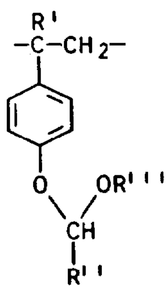
(IV)

worin x = 2 oder 3 ist, R' für H oder $CH_3$ steht, R'' und R''' untereinander gleich oder verschieden sind und für Alkyl mit 1 bis 4 Kohlenstoffatomen stehen, d.h. Copolymerisate aus p-Hydroxistyrol und 2-Tetrahydropyranyloxistyrol oder 2-Tetrahydrofuranyloxistyrol - wobei diese Copolymerisate auch durch polymeranaloge Umsetzung hergestellt sein können - . Es eignen sich auch Gemische der obengenannten Bindemittel (a). Bindemittel (a) ist im erfindungsgemäßen Gemisch im allgemeinen in Mengen von 80 bis 99, vorzugsweise 90 bis 97 Gew.-% bezogen auf die Gesamtmenge des strahlungsempfindlichen Gemisches (a)+(b) enthalten.

b) Als bei Bestrahlung eine starke Säure bildende Verbindungen (b) kommen Iodonium- und insbesondere Sulfoniumsalze in Frage. Diese entsprechen den allgemeinen Formeln (V) bzw. (VI)

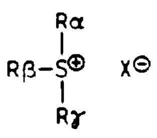
(V)

bzw.

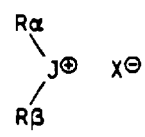
(VI)

worin

Rα, Rß und Rγ untereinander gleich oder verschieden sind und für Alkyl mit 1 bis 3 Kohlenstoffatomen, vorzugsweise Methyl oder Ethyl, Aryl, wie z.B. Phenyl oder Aralkyl, wie z.B. Benzyl, stehen, wobei mindestens einer der Reste Rα, Rβ und Rγ für einen Rest der Formel (VII)

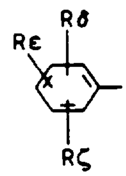

(VII)

steht, worin Rδ, Rε und Rζ untereinander gleich oder verschieden sind und für Wasserstoff, OH, Halogen, wie z. B. Chlor oder Brom, Alkyl, mit 1 bis 4 Kohlenstoffatomen, vorzugsweise Methyl oder tert.Butyl stehen und $X^{\ominus}$ = $AsF_6^{\ominus}$, $SbF_6^{\ominus}$, $PF_6^{\ominus}$, $BF_4^{\ominus}$, $CH_3SO_3^{\ominus}$, $ClO_4^{\ominus}$ oder $CF_3SO_3^{\ominus}$ ist.

Beispiele für besonders gut geeignete Komponenten (b) sind Triphenylsulfoniumsalze und Diphenyliodoniumsalze, Tris(4-hydroxiphenyl)sulfoniumsalz, jeweils mit $X^{\ominus}$ = $ClO_4^{\ominus}$, $AsF_6^{\ominus}$, $PF_6^{\ominus}$, $SbF_6^{\ominus}$, $BF_4^{\ominus}$, $CH_3SO_3^{\ominus}$ und/oder $CF_3SO_3^{\ominus}$ als Gegenionen.

Auch Gemische der unter (b) genannten Verbindungen können eingesetzt werden. Komponente (b) ist im erfindungsgemäßen strahlungsempfindlichen Gemisch im allgemeinen in Mengen von 1 bis 20, vorzugsweise 3 bis 10 Gew.%, bezogen auf die Gesamtmenge des strahlungsempfindlichen Gemisches (a)+(b), enthalten.

Das erfindungsgemäße strahlungsempfindliche Gemisch kann zusätzlich noch weitere übliche Hilfs- und Zusatzstoffe enthalten.

Die erfindungsgemäßen Gemische werden bevorzugt in einem organischen Lösungsmittel gelöst, wobei der Feststoffgehalt im allgemeinen im Bereich zwischen 5 und 40 Gew.% liegt. Als Lösungsmittel kommen bevorzugt aliphatische Ketone, Ether und Ester, sowie Mischungen derselben in Frage. Besonders bevorzugt sind Alkylenglykol-monoalkylether, wie beispielsweise Ethyl-cellosolve, Butylglykol, Methyl-cellosolve und 1-Methoxy-2-propanol, Alkylenglykol-alkylether-ester, wie beispielsweise Methyl-cellosolve-acetat, Ethyl-cellosolve-acetat, Methyl-propylenglykol-acetat und Ethyl-propylenglykol-acetat, Ketone, wie beispielsweise Cyclohexanon, Cyclopentanon und Methyl-ethyl-keton, sowie Acetate wie Butylacetat und Aromaten, wie Toluol und Xylol. Die Auswahl der entsprechenden Lösungsmittel, sowie deren Mischung richtet sich nach der Wahl des jeweiligen phenolischen Polymers, Novolaks und der photoempfindlichen Komponente.

Weiterhin können andere Zusätze wie Haftvermittler, Netzmittel, Farbstoffe und Weichmacher zugesetzt werden, im allgemeinen in Mengen von bis zu 1 Gew.-%.

Gegebenenfalls können auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind hierfür bevorzugt, jedoch können auch andere Farbstoffe, die als Sensibilisatoren wirken, verwendet werden.

Bei dem erfindungsgemäßen Verfahren zur Herstellung von Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche in wäßrig-alkalischen Lösungsmitteln zunimmt und diese bestrahlten Bereiche selektiv mit dem alkalischen Entwickler entfernt werden können.

Besondere Vorteile der erfindungsgemäßen strahlungsempfindlichen Gemische sind die damit erhältlichen sehr guten Struktureigenschaften (sehr steile Kanten, saubere Strukturen).

Die das erfindungsgemäße strahlungsempfindliche Gemisch enthaltenden Photoresistlösungen werden im allgemeinen in Schichtdicken von 0,1 bis 5 µm vorzugsweise 0,5 bis 1,5 µm auf geeignete Substrate, beispielsweise oberflächlich oxidierte Silizium-Wafer durch Aufschleudern (spin coating) aufgetragen, getrocknet (z.B. bei Temperaturen zwischen 70 und 130°C) und mit einer geeigneten Lichtquelle durch eine Photomaske bildmäßig belichtet. Als Lichtquellen eignen sich insbesondere kurzwellige UV-Strahlen (deep UV) mit Wellenlängen zwischen 200 und 300 nm. Besonders geeignete Lichtquellen sind Excimer-Laser von KrF (248 nm). Nach dem bildmäßigen Belichten wird - gegebenenfalls nach kurzem Ausheizen (postbake) bei Temperaturen bis zu 150°C - mit üblichen wäßrig-alkalischen Entwicklerlösungen - im allgemeinen bei pH-Werten zwischen 12 und 14 - entwickelt, wobei die belichteten Stellen ausgewaschen werden. Die Auflösung liegt im Submikron-Bereich. Die für die erfindungsgemäßen strahlungsempfindlichen Gemische benötigte Belichtungsenergie liegt im allgemeinen zwischen 50 und 300 $mJ/cm^2$ bei Schichtdicken von 1 µm.

Die in den Beispielen angegebenen Teile und Prozente sind, soweit nicht anders angegeben, Gewichtsteile bzw. Gewichtsprozente.

Die Herstellung der phenolischen Harze (a), deren phenolische Hydroxylgruppen teilweise durch Gruppierung (I) ersetzt sind, kann analog der in Helv. Chim. Acta 46, 415 (1963) gegebenen Vorschrift erfolgen.

Beispiel für die Herstellung von Poly(p-hydroxistyrol), dessen phenolische Hydroxylgruppen teilweise durch 2-Tetrahydropyranyl-gruppen geschützt sind:

10 Teile Poly(p-hydroxistyrol) (MG = 10.000) und 11 Teile 3,4-Dihydropyran werden in 90 Teilen Essigester aufgelöst; danach werden unter $N_2$-Atmosphäre 0,15 Teile konz. HCl (36%ige Lösung) zugegeben und bei Raumtemperatur so lange gerührt, bis das IR-Spektrum der Lösung identisch ist mit dem der Lösung des Gemisches aus Poly(p-hydroxistyrol) und 2-Tetrahydropyranyl-4-ethylphenylether (Verhälntis 1:1); d.h. 50 % der phenolischen OH-Gruppen sind durch Tetrahydropyranylgruppierungen geschützt. Das so erhaltene Produkt wird in 1.500 Teilen Ligroin gefällt, abgesaugt und bei 50°C unter Vakuum getrocknet. Das IR-Spektrum des Produkts nach dem Trocknen zeigt, daß etwa 50 % der OH-Gruppen durch Tetrahydropyranylgruppen geschützt sind.

Beispiel 1

Eine Photoresistlösung wird aus 95 Teilen eines, wie oben angegeben, aus Poly(p-hydroxistyrol) mit einem mittleren Molekulargewicht $\overline{M}_w$ von 10.000 hergestellten Produkts, dessen phenolische Hydroxylgruppen zu 50 % durch 2-Tetrahydropyranylgruppen geschützt sind, 5 Teile Triphenylsulfoniumhexafluoroarsenat und 250 Teilen Ethylenglykol-monomethyletheracetat hergestellt.

Die Lösung wird anschließend durch ein Filter mit einem Porendurchmesser von 0,2 µm filtriert.

Die Resistlösung wird auf einen Siliciumwafer, der mit Hexamethyldisilazan als Haftvermittler überzogen ist, mit 4000 Upm/30 Sekunden aufgeschleudert, wobei eine Schichtdicke von etwa 1 µm erhalten wird. Der Wafer wird während 3 Minuten auf einer Heizplatte bei 80°C getrocknet, anschließend mit einer bildmäßig strukturierten Testmaske in Kontakt gebracht und mit einem Excimer-Laser ($\lambda$ = 248 nm, E = 35 mW/cm$^2$) belichtet. Danach wird der Wafer 1 Minute bei 80°C ausgeheizt und mit einem Entwickler vom pH-Wert 12,0-13,6 entwickelt. Die Lichtempfindlichkeit beträgt 80 mJ/cm$^2$.

Es ist kein Dunkelabtrag (= Schichtdickenverlust der unbelichteten Stellen nach der Entwicklung) feststellbar.

Vergleichsbeispiel 1

Es wird wie in Beispiel 1 beschrieben, jedoch unter Ersatz der 95 Teile Poly(p-hydroxistyrol), dessen phenolische Hydroxylgruppen zu 50 % durch 2-Tetrahydropyranylgruppen geschützt sind, durch 95 Teile Poly(p-hydroxistyrol), dessen phenolische Hydroxylgruppen nur zu 15 % durch 2-Tetrahydropyranylgruppen geschützt sind, eine Photoresistlösung hergestellt und weiterverarbeitet. Die Lichtempfindlichkeit beträgt in diesem Falle 65 mJ/cm$^2$, der Dunkelabtrag jedoch etwa 20 %, was nicht mehr akzeptabel ist.

Vergleichsbeispiel 2

Es wird wie in Beispiel 1 beschrieben, jedoch unter Ersatz der 95 Teile Poly(p-hydroxistyrol), dessen phenolische Hydroxylgruppen zu 50 % durch 2-Tetrahydropyranylgruppen geschützt sind, durch 95 Teile Poly(p-hydroxistyrol), dessen phenolische Hydroxylgruppen zu 80 % durch 2-Tetrahydropyranylgruppen geschützt sind, eine Photoresistlösung hergestellt und weiterverarbeitet. Der so erhaltene Resist erweist sich bei einer Lichtempfindlichkeit von 100 mJ/cm$^2$ als positiv arbeitend, bei einer Lichtempfindlichkeit von 150 mJ/cm$^2$ als negativ arbeitend, d.h. mit starker Restschichtbildung.

Beispiel 2

Es wird wie in Beispiel 1 beschrieben, jedoch unter Ersatz der 5 Teile Triphenylsulfoniumhexafluoroarsenat durch 5 Teile Diphenyljodoniumhexafluorophosphat eine Photoresistlösung hergestellt und weiterverarbeitet. Die Lichtempfindlichkeit beträgt 270 mJ/cm$^2$.

Beispiel 3

Es wird wie in Beispiel 1 beschrieben, jedoch unter Ersatz der 5 Teile Triphenylsulfoniumhexafluoroarsenat durch 5 Teile Tris(4-hydroxiphenyl)sulfoniumtriflat eine Photoresistlösung hergestellt und weiterverarbeitet. Die Lichtempfindlichkeit beträgt 90 mJ/cm$^2$.

Beispiel 4

Es wird wie in Beispiel 3 beschrieben eine Photoresistlösung hergestellt und weiterverarbeitet, doch wird nach dem Belichten nicht bei 80°C ausgeheizt, d.h. ohne postbake gearbeitet. Die Lichtempfindlichkeit beträgt 130 mJ/cm$^2$.

Beispiel 5

Es wird, wie in Beispiel 3 beschrieben, eine Photoresistlösung hergestellt und weiterverarbeitet, doch wird nach

dem Belichten nicht bei 80°C, sondern bei 120°C ausgeheizt. Die Lichtempfindlichkeit beträgt 60 $mJ/cm^2$.

Beispiel 6

Es wird, wie in Beispiel 3 beschrieben, eine Photoresistlösung hergestellt, jedoch werden anstatt 95 Teilen 97 Teile Poly(p-hydroxistyrol), dessen phenolische Hydroxylgruppen zu 50 % durch 2-Tetrahydropyranylgruppen geschützt sind, und anstatt 5 Teilen 3 Teile Tris(4-hydroxiphenyl)sulfoniumtriflat eingesetzt. Die Weiterverarbeitung erfolgt wie in Beispiel 1 beschrieben. Die Lichtempfindlichkeit beträgt 100 $mJ/cm^2$.

## Patentansprüche

1. Strahlungsempfindliches Gemisch, im wesentlichen bestehend aus

   (a) einem in Wasser unlöslichen, in wäßrig-alkalischen Lösungen löslichen Bindemittel oder Bindemittelgemisch und
   (b) einer bei Bestrahlung eine starke Säure bildenden Verbindung,

   dadurch gekennzeichnet, daß Komponente (a) ein phenolisches Harz ist, dessen phenolische Hydroxylgruppen zu 20 bis 70 % durch Gruppierungen (I)

   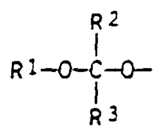

   (I),

   worin

   $R^1$ für Alkyl steht,
   $R^2$ für Alkyl steht und
   $R^3$ für Wasserstoff oder Alkyl steht,

   oder $R^1$ zusammen mit $R^2$ über $-(CH_2)_m-$ mit m = 3 bis 6 einen Ring bildet,
   ersetzt wird, und als Komponente (b) ein Sulfonium- oder Jodoniumsalz der allgemeinen Formeln (V) oder (VI)

   (V) 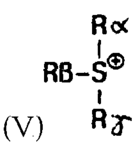 bzw. 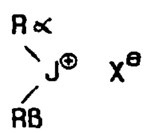 (VI)

   eingesetzt wird, worin Rα, Rβ und Rγ untereinander gleich oder verschieden sind und für Alkyl mit 1 bis 3 Kohlenstoffatomen, Aryl
   oder Aralkyl stehen und $X^{\ominus} = ClO_4^{\ominus}$, $AsF_6^{\ominus}$, $SbF_6^{\ominus}$, $PF_6^{\ominus}$, $BF_4^{\ominus}$, $CH_3SO_3^{\ominus}$ und/oder $CF_3SO_3^{\ominus}$ ist, wobei mindestens einer der Reste Rα, Rβ und Rγ für einen Rest der allgemeinen Formel (VII)

   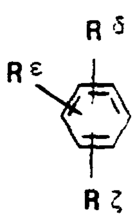

   (VII)

   steht, worin Rδ, Rε und Rζ untereinander gleich oder verschieden sind und für H, OH, Halogen oder Alkyl mit 1 bis 4 Kohlenstoffatomen stehen.

2. Strahlungsempfindliches Gemisch nach Anspruch 1, dadurch gekennzeichnet, daß als Komponente (a) ein Gemisch aus einem phenolischen Harz und einem davon verschiedenen Novolak eingesetzt wird.

3. Strahlungsempfindliches Gemisch nach Anspruch 1, dadurch gekennzeichnet, daß als Komponente (a) Poly-(-p-hydroxistyrol) oder Poly-(p-hydroxi-α-methylstyrol) mit mittleren Molekulargewichten $\overline{M}_w$ zwischen 200 und 200

000 eingesetzt wird, wobei 20 bis 70 % der Hydroxylgruppen durch die Gruppierung (I) ersetzt sind.

**4.** Strahlungsempfindliches Gemisch nach einem der vorhergehenden Ansprüche, dadurch gekennzeichnet, daß Komponente (a) Gruppierungen (II) und (III) oder (II) und (IV)

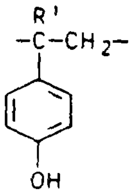
(II)

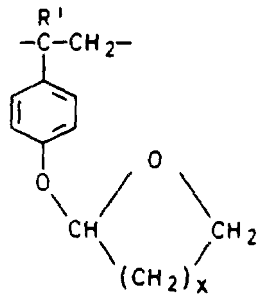
(III)

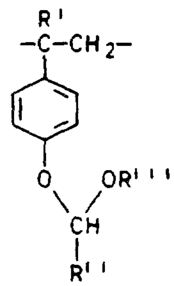
(IV)

enthält, wobei x = 2 oder 3 ist, R' für H oder $CH_3$ steht, R'' und R''' untereinander gleich oder verschieden sind und für Alkyl mit 1 bis 4 Kohlenstoffatomen stehen.

**5.** Strahlungsempfindliches Gemisch nach einem der vorhergehenden Ansprüche, dadurch gekennzeichnet, daß als Bindemittel (a) ein Copolymerisat aus p-Hydroxystyrol und 2-Tetrahydropyranyloxistyrol oder 2-Tetrahydrofuranyloxistyrol - wobei diese Copolymerisate auch durch polymeranaloge Umsetzung hergestellt sein können - eingesetzt wird.

**6.** Strahlungsempfindliches Gemisch nach einem der vorhergehenden Ansprüche, dadurch gekennzeichnet, daß Komponente (a) in einer Menge von 80 bis 99 Gew.-% und Komponente (b) in einer Menge von 1 bis 20 Gew.-% enthalten ist.

**7.** Strahlungsempfindliches Gemisch nach einem der vorhergehenden Ansprüche, dadurch gekennzeichnet, daß es zusätzlich einen Sensibilisator enthält, der Strahlung absorbiert und auf Komponente (b) überträgt.

**8.** Strahlungsempfindliches Gemisch nach einem der vorhergehenden Ansprüche, dadurch gekennzeichnet, daß es zusätzlich bis zu 1 Gew.-% eines Haftvermittlers, Tensids oder Farbstoffe enthält.

**9.** Verfahren zur Herstellung lichtempfindlicher Beschichtungsmaterialien, dadurch gekennzeichnet, daß ein strahlungsempfindliches Gemisch gemäß einem der Ansprüche 1 bis 8 eingesetzt wird.

**10.** Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 130°C, bildmäßiges Belichten, gegebenenfalls Erhitzen auf Temperaturen von 70 bis 160°C, und Entwickeln mit einer wäßrig-alkalischen Lösung, dadurch gekennzeichnet, daß ein strahlungsempfindliches Gemisch nach einem der Ansprüche 1 bis 8 eingesetzt wird.

## Claims

**1.** A radiation-sensitive mixture consisting essentially of

(a) a water-insoluble but alkali-soluble binder or binder mixture and
(b) a compound which forms a strong acid on irradiation, wherein component (a) is a phenolic resin whose phenolic hydroxyl groups have been replaced to an extent of from 20 to 70% by groups (I)

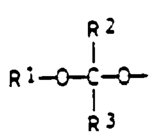
(I)

where

$R^1$ is alkyl,
$R^2$ is alkyl and
$R^3$ is hydrogen or alkyl,

or $R^1$ together with $R^2$ forms a ring via $-(CH_2)_m-$, where m is from 3 to 6, and component (b) is a sulfonium or iodonium salt of the general formula (V) or (VI)

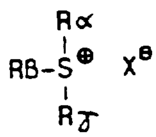
(V)

or

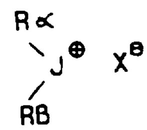
(VI)

where Rα, Rβ and Rγ are identical to or different from one another and each is alkyl of from 1 to 3 carbon atoms, aryl or aralkyl and $X^{\ominus}$ is $ClO_4^{\ominus}$, $AsF_6^{\ominus}$, $SbF_6^{\ominus}$, $PF_6^{\ominus}$, $BF_4^{\ominus}$, $CH_3SO_3^{\ominus}$ and/or $CF_3SO_3^{\ominus}$, at least one of Rα, Rβ and Rγ being a radical of the general formula (VII)

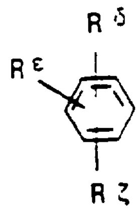
(VII)

where Rδ, Rε and Rζ are identical to or different from one another and each is hydrogen, hydroxyl, halogen or alkyl of from 1 to 4 carbon atoms.

2. A radiation-sensitive mixture as claimed in claim 1, wherein component (a) is a mixture of a phenolic resin and a different novolak.

3. A radiation-sensitive mixture as claimed in claim 1, wherein component (a) is a poly(p-hydroxystyrene) or poly(p-hydroxy-α-methylstyrene) having an average molecular weight $\overline{M}_w$ of from 200 to 200,000 in which from 20 to 70% of the hydroxyl groups have been replaced by group (I).

4. A radiation-sensitive mixture as claimed in any one of the preceding claims, wherein component (a) contains groups (II) and (III) or (II) and (IV)

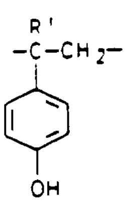
(II)

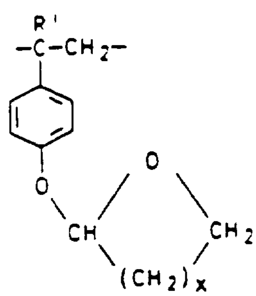
(III)

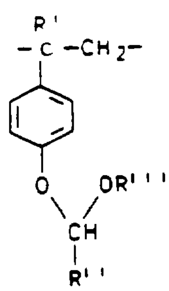
(IV)

where x is 2 or 3, R' is hydrogen or methyl and R'' and R''' are identical to or different from each other and each is alkyl of from 1 to 4 carbon atoms.

5. A radiation-sensitive mixture as claimed in any one of the preceding claims, wherein binder (a) is a copolymer of p-hydroxystyrene and 2-tetrahydropyranyloxystyrene or 2-tetrahydrofuranyloxystyrene, which copolymer may in

either case have been prepared by polymer-analogous reaction.

**6.** A radiation-sensitive mixture as claimed in any one of the preceding claims, wherein component (a) is present in an amount of from 80 to 99% by weight and component (b) in an amount of from 1 to 20% by weight.

**7.** A radiation-sensitive mixture as claimed in any one of the preceding claims, additionally containing a sensitizer which absorbs radiation and transfers it to component (b).

**8.** A radiation-sensitive mixture as claimed in any one of the preceding claims, additionally containing up to 1% by weight of an adhesion promoter, surfactant or dye.

**9.** A process for preparing a light-sensitive coating material, which comprises using a radiation-sensitive mixture as claimed in any of claims 1 to 8.

**10.** A process for producing a relief structure by application of a radiation-sensitive mixture in a thickness of from 0.1 to 5 µm to a conventionally pretreated substrate, drying at 70 - 130°C, imagewise exposure, optionally heating to 70 - 160°C and development in aqueous alkali, which comprises using a radiation-sensitive mixture as claimed in any of claims 1 to 8.

**Revendications**

**1.** Mélange sensible en rayonnement, constitué essentiellement de

a) un liant ou mélange de liants insoluble dans l'eau, soluble dans des solutions alcalines-aqueuses et

b) un composé formant un acide fort par rayonnement,

caractérisé par le fait que le composant (a) est une résine phénolique dont le groupe hydroxyle phénolique est remplacé, jusqu'à 20 à 70 %, par un groupement (1)

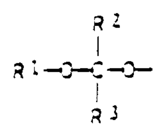
(I),

dans lequel

$R^1$ est mis pour alkyle
$R^2$ est mis pour alkyle et
$R^3$ est mis pour hydrogène ou alkyle

ou $R^1$ forme un noyau avec $R^2$, par l'intermédiaire de $-(CH_2)_m-$ avec m = 3 à 6
et, comme composant (b), est utilisé un sel de sulfonium ou d'iodonium de formule générale (V) ou (VI)

(V) 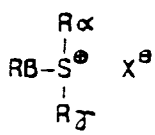 ou 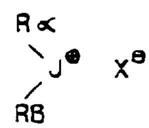 (VI)

dans laquelle Rα, Rβ et Rγ sont identiques ou différents les uns des autres et sont mis pour alkyle de 1 à 3 atomes de carbone, aryle ou aralkyle et $X^\theta = ClO_4^\theta$, $AsF_6^\theta$, $SbF_6^\theta$, $PF_6^\theta$, $BF_4^\theta$ , $CH_3SO_3^\theta$ et/ou $CF_3SO_3^\theta$, un des restes Rα, Rβ, Rγ étant mis pour un reste de la formule générale VII

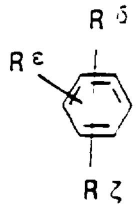

(VII)

où Rδ, Rε et Rζ sont identiques ou différents l'un de l'autre et sont mis pour H, OH, halogène ou alkyle à 1 à 4 atomes de carbone.

**2.** Mélange sensible au rayonnement selon la revendication 1, caractérisé par le fait que l'on utilise, comme composant (a), un mélange d'une résine phénolique et d'une novolaque différente de celle-ci.

**3.** Mélange sensible au rayonnement selon la revendication 1, caractérisé par le fait que l'on utilise, comme composant (a), du poly-(p-hydroxystyrène) ou poly-(p-hydroxy-α-méthylstyrène) d'un poids moléculaire moyen $\overline{M}_W$ compris entre 200 et 200000, 20 à 70 % des groupes hydroxyles étant remplacés par le groupement (I).

**4.** Mélange sensible au rayonnement selon l'une des revendications précédentes, caractérisé par le fait que le composant (a) contient des groupements (II) et (III) ou (II) et (IV)

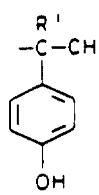

(II)

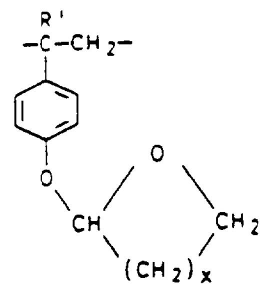

(III)

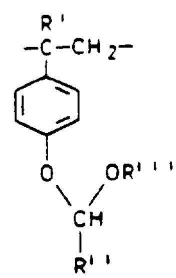

(IV)

où x = 2 ou 3, R' est mis pour H ou CH3, R'' et R''' étant identiques ou différents l'un de l'autre et sont mis pour alkyle de 1 à 4 atomes de carbone.

**5.** Mélange sensible au rayonnement selon l'une des revendications précédentes, caractérisé par le fait que, comme liant (a), est utilisé un copolymérisat de p-hydroxystyrène et 2-tétrahydropyranyloxistyrène ou 2-tétrahydrofuranyloxistyrène, ce copolymérisat pouvant être préparé aussi par une réaction analogue à polymérisation.

**6.** Mélange sensible au rayonnement selon l'une des revendications précédentes, caractérisé par le fait que le composant (a) est contenu en proportion de 80 à 99 % en poids et le composant (b) en proportion de 1 à 20 % en poids.

**7.** Mélange sensible au rayonnement selon l'une des revendications précédentes, caractérisé par le fait qu'il contient additionnellement un sensibilisateur qui absorbe le rayonnement et transmet sur le composant (b).

**8.** Mélange sensible au rayonnement selon l'une des revendications précédentes, caractérisé par le fait qu'il contient, en outre, jusqu'à 1 % en poids d'un intermédiaire d'adhérence, de tensio-actifs, et de colorant.

**9.** Procédé de préparation de matières d'enduction sensibles à la lumière, caractérisé par le fait que l'on utilise un mélange sensible au rayonnement selon l'une des revendications 1 à 8.

**10.** Procédé de préparation de structures en relief par application d'un mélange sensible au rayonnement en une épaisseur de couche de 0,1 à 5 µm sur un substrat pré-traité de manière usuelle, séchage à des températures de 70 à 130°C, éclairage en fonction d'une image, éventuellement réchauffage à des températures de 70 à 160°C et développement avec une solution alcaline-aqueuse, caractérisé par le fait que l'on utilise un mélange sensible au rayonnement selon l'une des revendications 1 à 8.